(19) **Europäisches Patentamt / European Patent Office / Office européen des brevets**

(11) **EP 4 770 308 A1**

(12) **EUROPEAN PATENT APPLICATION**
published in accordance with Art. 153(4) EPC

(43) Date of publication:
**01.07.2026 Bulletin 2026/27**

(21) Application number: 25734736.9

(22) Date of filing: **13.03.2025**

(51) International Patent Classification (IPC):
**H10B 12/00** (2023.01)

(52) Cooperative Patent Classification (CPC):
**H10B 12/0335; H10W 20/031; H10W 20/422;**
**H10B 12/315; H10B 12/482**

(86) International application number:
**PCT/CN2025/082240**

(87) International publication number:
**WO 2026/091369 (07.05.2026 Gazette 2026/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.10.2024 CN 202411538538**

(71) Applicant: **CXMT Corporation
Hefei, Anhui 230601 (CN)**

(72) Inventors:
• **ZHU, Shun**
  **Hefei, Anhui 230601 (CN)**

• **CHEN, Longyang**
  **Hefei, Anhui 230601 (CN)**
• **SHI, Luan**
  **Hefei, Anhui 230601 (CN)**
• **FANG, Ke**
  **Hefei, Anhui 230601 (CN)**
• **CHEN, Yinchu**
  **Hefei, Anhui 230601 (CN)**
• **SUN, Yao**
  **Hefei, Anhui 230601 (CN)**
• **LI, Guangcheng**
  **Hefei, Anhui 230601 (CN)**

(74) Representative: **Gulde & Partner
Patent- und Rechtsanwaltskanzlei mbB
Berliner Freiheit 2
10785 Berlin (DE)**

(54) **SEMICONDUCTOR STRUCTURE AND MANUFACTURING METHOD THEREFOR**

(57)    Disclosed are a semiconductor structure and a forming method therefor. The semiconductor structure may include at least the following: a substrate; bit line structures, located on the substrate, multiple bit line structures extending in a first direction and being disposed at intervals in a second direction, and the first direction being perpendicular to the second direction; first dielectric layers, each of the first dielectric layers being located between adjacent ones of the bit line structures, and the first dielectric layers being disposed at intervals in the first direction; contact structures, each of the contact structures being located between adjacent ones of the bit line structures, and the contact structures and the first dielectric layers being alternately disposed; and conductive structures, located above the contact structures, the tops of the conductive structures being flush with the tops of the first dielectric layers; the contact structures being gradually decreased in size from the tops of the contact structures to a surface of the substrate in a direction perpendicular to the substrate.

FIG. 21

EP 4 770 308 A1

Description

CROSS-REFERENCE TO RELATED APPLICATIONS

This application claims priority to Chinese Patent Application No. 202411538538.8, filed on October 30, 2024 and entitled "SEMICONDUCTOR STRUCTURE AND FORMING METHOD THEREFOR", which is incorporated herein by reference in its entirety.

TECHNICAL FIELD

Embodiments of the present disclosure relate to the semiconductor field, and in particular, to a semiconductor structure and a forming method therefor.

BACKGROUND

In a manufacturing process of dynamic random access memories (DRAM), constantly reduced chip sizes are accompanied with increasingly prominent process challenges, possibly leading to problems such as deterioration of performance of a connection between a conductive structure and a contact structure and a short circuit between adjacent conductive structures or adjacent contact structures.

SUMMARY

Embodiments of the present disclosure provide a semiconductor structure and a forming method therefor, which are conducive to solving at least the problems of deterioration of a pad structure and a contact node as well as a short circuit between different conductive structures.

According to some embodiments of the present disclosure, one aspect of the embodiments of the present disclosure provides a semiconductor structure, including:

a substrate;
bit line structures, located on the substrate, multiple bit line structures extending in a first direction and being disposed at intervals in a second direction, and the first direction being perpendicular to the second direction;
first dielectric layers, each of the first dielectric layers being located between adjacent ones of the bit line structures, and the first dielectric layers being disposed at intervals in the first direction;
contact structures, each of the contact structures being located between adjacent ones of the bit line structures, and the contact structures and the first dielectric layers being alternately disposed; and
conductive structures, located above the contact structures, tops of the conductive structures being flush with tops of the first dielectric layers;
the contact structures being gradually decreased in size from tops of the contact structures to a surface of the substrate in a direction perpendicular to the substrate.

In some embodiments, each of the conductive structures includes a first conductive structure and a second conductive structure, the first conductive structure is flush with top surfaces of the first dielectric layers, the second conductive structure is located between the first conductive structure and one of the contact structures, and the conductive structure is gradually increased in size from top to bottom in the direction perpendicular to the substrate.

In some embodiments, a contact area between each of the conductive structures and each of the contact structures is greater than a cross-sectional area of the conductive structure at any position and greater than a cross-sectional area of the contact structure at any position.

In some embodiments, the semiconductor structure further includes top conductive structures, located above the conductive structures and covering parts of top surfaces of the first dielectric layers.

In some embodiments, each of the first dielectric layers is first decreased and then increased in size from top to bottom, the first dielectric layer further has an air gap therein, and the air gap is lower than an interface between each of the conductive structures and each of the contact structures.

In some embodiments, each of the contact structures includes a first contact structure and a second contact structure, the first contact structure is embedded in the substrate, the second contact structure is located above the first contact structure, and the second contact structure is gradually decreased in size from top to bottom in the direction perpendicular to the substrate.

Another aspect of the embodiments of the present disclosure provides a forming method for a semiconductor structure, including the following steps:

a substrate is provided;
bit line structures are formed on the substrate, the bit line structures extending in a first direction and being disposed at intervals in a second direction, the first direction being perpendicular to the second direction, and first openings each being present between adjacent ones of the bit line structures;
a first conductive layer is formed in the first openings;
the first conductive layer is etched in a third direction to form second openings, remainders of the first conductive layer serving as second conductive layers, the second conductive layers and the second openings being alternately disposed in the first direction, and the third direction being perpendicular to the substrate;
the second openings are filled with first dielectric layers;
the second conductive layers are etched back to form third openings, remainders of the second conductive layers serving as contact structures; and conductive structures are formed in the third openings, the conductive structures being located above the contact structures;

the contact structures being gradually decreased in size from tops of the contact structures to a surface of the substrate in a direction perpendicular to the substrate.

In some embodiments, each of the conductive structures includes a first conductive structure and a second conductive structure, the first conductive structure is located in one of the third openings and flush with top surfaces of the first dielectric layers, the second conductive structure is located between the first conductive structure and one of the contact structures, and the conductive structure is gradually increased in size from top to bottom in the direction perpendicular to the substrate.

In some embodiments, a contact area between each of the conductive structures and each of the contact structures is greater than a cross-sectional area of the conductive structure at any position and greater than a cross-sectional area of the contact structure at any position.

In some embodiments, top conductive structures are further included, the top conductive structures being formed above the conductive structures and covering parts of top surfaces of the first dielectric layers.

In some embodiments, each of the first dielectric layers is first decreased and then increased in size from top to bottom, the first dielectric layer further has an air gap therein, and the air gap is lower than an interface between each of the conductive structures and each of the contact structures.

In some embodiments, each of the second conductive layers is first increased and then decreased in size from top to bottom, and a forming method for the second conductive layers includes the following step: an oxidation process, an etching process, and a deoxidation process are cyclically performed.

In some embodiments, the oxidation process is performed through oxygen, a bias power for the oxidation process is gradually increased, and a flow rate of the oxygen is gradually increased; an etching gas for the etching process is chlorine and/or a hydrogen bromide gas, a regulating gas for the etching process is oxygen, a flow rate of the etching gas remains unchanged, and a flow rate of the regulating gas is first increased and then decreased; and the deoxidation process removes, through a plasma, a by-product produced during the etching, and a bias power of the deoxidation process is gradually increased.

In some embodiments, before the first conductive layer is formed, the forming method further includes the following step: the substrate continues to be etched along the first openings to form first initial openings, the first initial openings being further filled with the first conductive layer.

In some embodiments, each of the contact structures includes a first contact structure and a second contact structure, the first contact structure is located in one of the first initial openings, the second contact structure is located above the first contact structure, and the second contact structure is gradually decreased in size from top to bottom in the direction perpendicular to the substrate.

In some embodiments, before the first conductive layer is etched in the third direction to form the second openings, the forming method further includes the following steps: a stacked film layer is formed on the first conductive layer, the stacked film layer is etched to form second initial openings, and the first conductive layer is etched along the second initial openings to form the second openings.

In some embodiments, that the second openings are filled with first dielectric layers specifically includes the following step:

the second openings are filled with a first initial dielectric layer, the first initial dielectric layer further covering surfaces of the second conductive layers; the first initial dielectric layer is etched back to form fourth openings; a second initial dielectric layer is formed in the fourth openings; and the first dielectric layers are formed by the first initial dielectric layer and the second initial dielectric layer together.

According to the technical solutions provided in the embodiments of the present disclosure, each of the contact structures is gradually decreased in size from the top of the contact structure to the surface of the substrate in the direction perpendicular to the substrate, that is, the top of the contact structure has a larger size, so that the contact area between the contact structure and the conductive structure formed in a later phase is relatively large, thereby improving connection performance. In addition, distances between adjacent contact structures and between adjacent conductive structures are relatively long, thereby preventing occurrence of a short circuit.

**BRIEF DESCRIPTION OF DRAWINGS**

One or more embodiments are exemplified with the figures in the accompanying drawings corresponding to the one or more embodiments. These example descriptions are not intended to limit the embodiments, and unless specifically stated, no scale limitations are constituted by the figures in the accompanying drawings. To describe the technical solutions in the embodiments of the present disclosure or the conventional technologies more clearly, the accompanying drawings required by the embodiments are briefly described below. Clearly, the accompanying drawings in the following description show merely some embodiments of the present disclosure, and other drawings may be obtained by a person of ordinary skill in the art from these accompanying drawings without creative efforts.

FIG. 1 is a schematic top view of a semiconductor structure according to an embodiment of the present disclosure;
FIG. 2 to FIG. 20 are process flowcharts of a forming method for a semiconductor structure according to an embodiment of the present disclosure, where FIG. 2 to FIG. 5 are cross-sectional views in a B-B' direction in FIG. 1, FIG. 6 to FIG. 20 are cross-sectional views in a D-D' direction in FIG. 1, and FIG. 17 is a schematic top view of FIG. 16;
FIG. 21 is a schematic diagram of a semiconductor structure according to an embodiment of the present disclosure; and
FIG. 22 is a schematic diagram of a semiconductor structure according to another embodiment of the present disclosure.

## DESCRIPTION OF EMBODIMENTS

It can be learned from the BACKGROUND that, in a manufacturing process of dynamic random access memories (DRAM), constantly reduced chip sizes are accompanied with increasingly prominent process challenges, possibly leading to problems such as deterioration of performance of a connection between a conductive structure and a contact structure and a short circuit between adjacent conductive structures or adjacent contact structures.

Embodiments of the present disclosure provide a semiconductor structure and a forming method therefor. Each of contact structures is gradually decreased in size from the top of the contact structure to a surface of a substrate in a direction perpendicular to the substrate, that is, the top of the contact structure has a larger size, so that a contact area between the contact structure and a conductive structure formed in a later phase is relatively large, thereby improving connection performance. In addition, distances between adjacent contact structures and between adjacent conductive structures are relatively long, thereby preventing occurrence of a short circuit.

The embodiments of the present disclosure are described in detail below with reference to the accompanying drawings. However, it may be understood by a person of ordinary skill in the art that in the embodiments of the present disclosure, many technical details are provided to enable readers to better understand the present disclosure. However, the technical solutions claimed in the present disclosure may be implemented even without these technical details and various variations and modifications made based on the following embodiments.

In the following paragraphs, the present disclosure is described more specifically by way of example with reference to the accompanying drawings. The advantages and features of the present disclosure will be clearer from the following description and claims. It should be noted that the accompanying drawings are presented in a highly simplified form and are not drawn to exact scale, and are merely intended to conveniently and clearly assist in describing the embodiments of the present disclosure.

It may be understood that meanings of "on", "over", and "above" in the present disclosure should be understood in the broadest sense, so that "on" means that it is "on" something with no intermediate feature or layer (that is, directly on something), and further includes the meaning that it is "on" something with an intermediate feature or layer.

In the embodiments of the present disclosure, the terms "first", "second", "third", and the like are intended to distinguish between similar objects but do not necessarily describe a specific order or sequence.

In the embodiments of the present disclosure, the term "layer" refers to a material part including a region having a thickness. The layer may extend over the whole of a lower or upper structure, or may have a range smaller than the range of the lower or upper structure. In addition, the layer may be a region of a homogeneous or heterogeneous continuous structure whose thickness is less than the thickness of a continuous structure. For example, the layer may be located between the top surface and the bottom surface of the continuous structure, or the layer may be located between any horizontal surface pair at the top surface and the bottom surface of the continuous structure. The layer may extend horizontally, vertically, and/or along an inclined surface. The layer may include multiple sublayers.

It should be noted that the technical solutions described in the embodiments of the present disclosure may be randomly combined when there is no conflict.

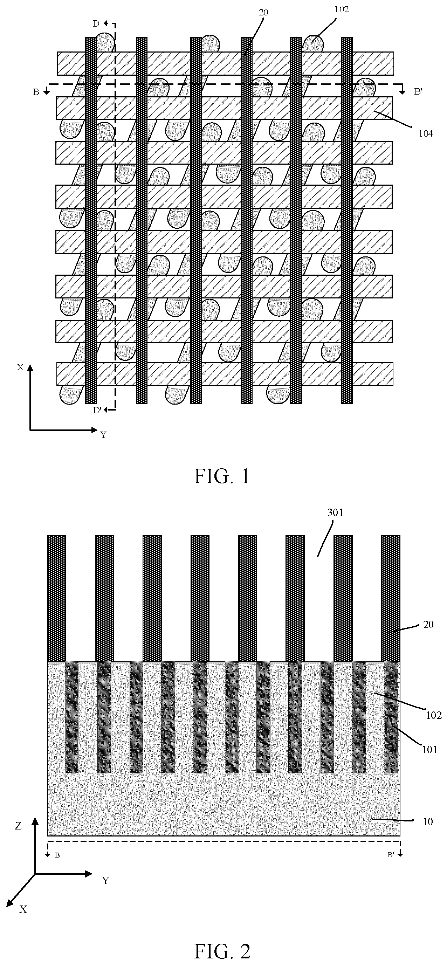

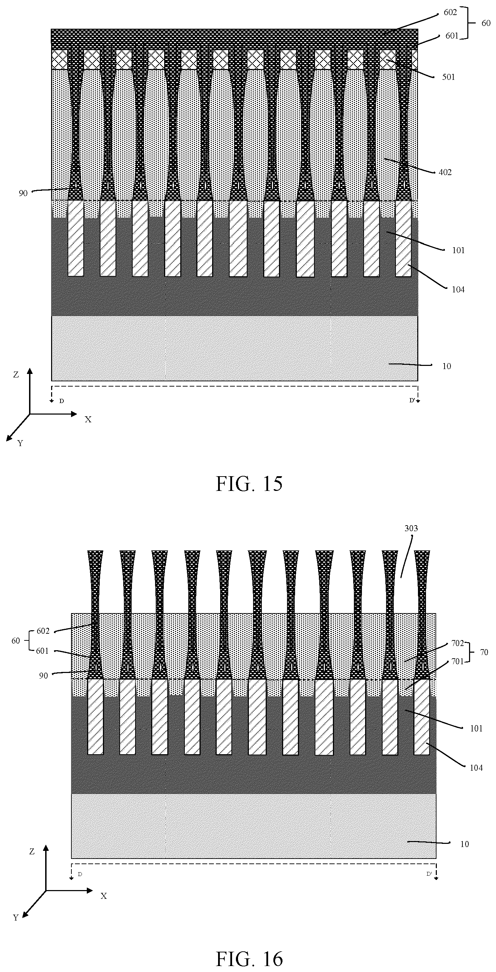

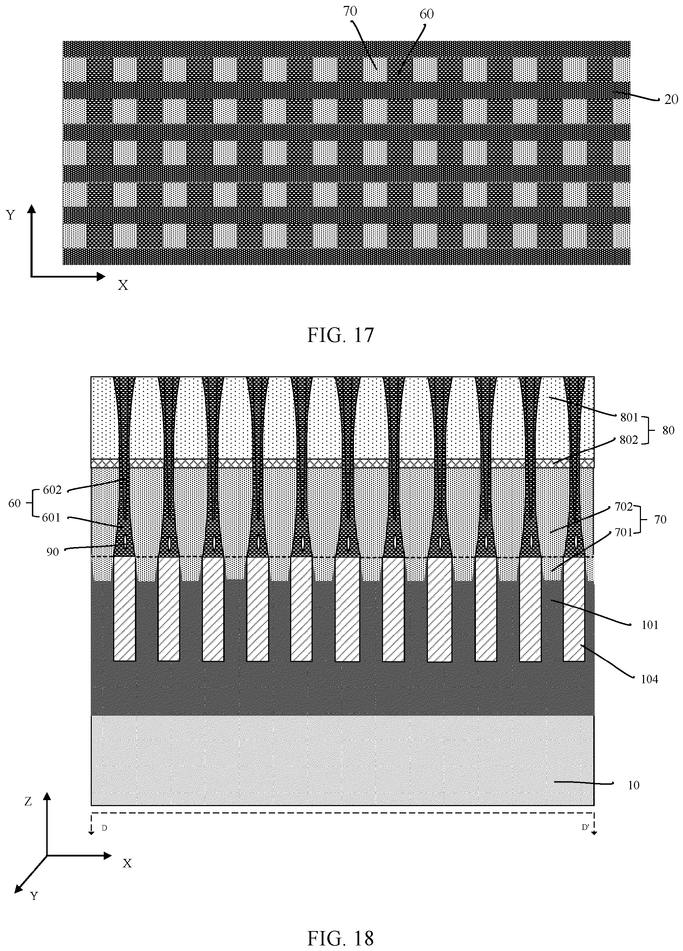

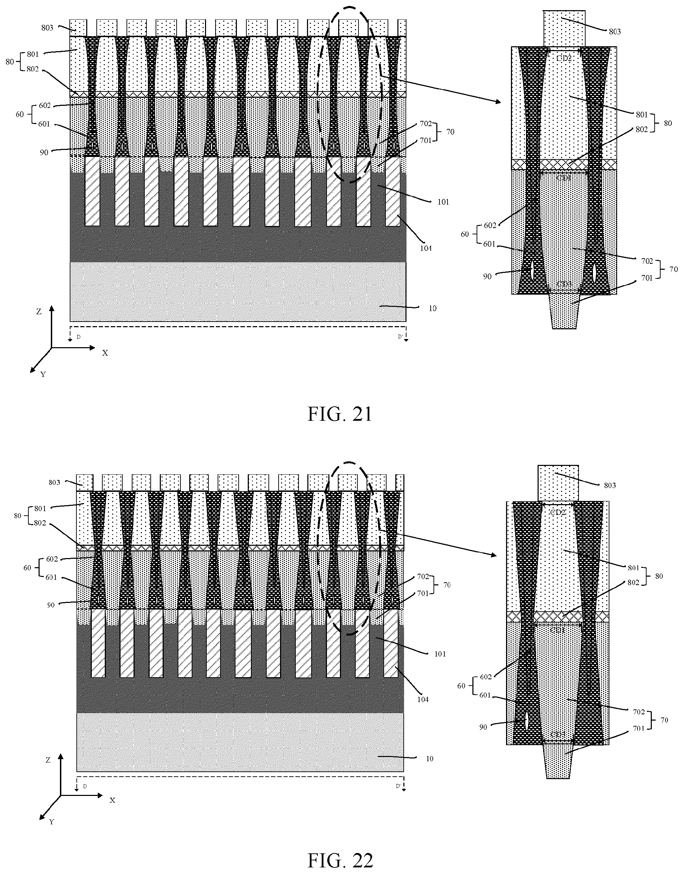

FIG. 1 is a schematic top view of a semiconductor structure according to an embodiment of the present disclosure; FIG. 2 to FIG. 20 are process flowcharts of a forming method for a semiconductor structure according to an embodiment of the present disclosure, where FIG. 2 to FIG. 5 are cross-sectional views in a B-B' direction in FIG. 1, FIG. 6 to FIG. 20 are cross-sectional views in a D-D' direction in FIG. 1, and FIG. 17 is a schematic top view of FIG. 16; FIG. 21 is a schematic diagram of a semiconductor structure according to an embodiment of the present disclosure; and FIG. 22 is a schematic diagram of a semiconductor structure according to another embodiment of the present disclosure.

Referring to FIG. 1, for ease of subsequent description, a schematic top view of a semiconductor structure is provided herein. The semiconductor structure includes the following: active regions 102, the active regions 102 extending in an inclined direction, multiple active regions 102 being disposed at intervals in an extension direction and a direction perpendicular to the extension direction, and a blank area between adjacent active regions 102 being an isolation structure (not shown in the figure); word line structures 104 each passing through multiple active regions 102, the word line structures 104 extending in a second direction Y, and adjacent word line structures 104 being disposed at intervals in a first direction X; and bit line structures 20 extending in the first direction X, multiple bit line structures 20 being disposed at intervals in the second direction Y.

FIG. 2 to FIG. 20 are process flowcharts of a forming method for a semiconductor structure according to an embodiment of the present disclosure, where FIG. 2 to FIG. 5 are cross-sectional views in a B-B' direction in FIG. 1, and FIG. 6 to FIG. 20 are cross-sectional views in a D-D' direction in FIG. 1. Because structures presented in different sectioning directions are different, to more clearly present the inventive concept of this application, FIG. 2 to FIG. 5 are cross-sectional views in the B-B' direction in FIG. 1, and FIG. 6 to FIG. 20 are cross-sectional views in the D-D' direction in FIG. 1.

This application provides a forming method for a semiconductor structure, including the following steps: a substrate 10 is provided; bit line structures 20 are formed on the substrate 10, the bit line structures 20 extending in a first direction X and being disposed at intervals in a second direction Y, the first direction X being perpendicular to the second direction Y, and first openings 301 each being present between adjacent ones of the bit line structures 20; a first conductive layer 401 is formed in the first openings 301; the first conductive layer 401 is etched in a third direction Z to form second openings 302, remainders of the first conductive layer 401 serving as second conductive layers 402, the second conductive layers 402 and the second openings 302 being alternately disposed in the first direction X, and the third direction Z being perpendicular to the substrate; the second openings 302 are filled with first dielectric layers 60; the second conductive layers 402 are etched back to form third openings 303, remainders of the second conductive layers 402 serving as contact structures 70; and conductive structures 80 are formed in the third openings 303, the conductive structures 80 being located above the contact structures 70; the contact structures 70 being gradually decreased in size from tops of the contact structures 70 to a surface of the substrate 10 in a direction perpendicular to the substrate 10.

Specifically, referring to FIG. 2, the forming method for a semiconductor structure includes the following steps: the substrate 10 is provided, the substrate 10 including isolation structures 101, active regions 102 each being present between adjacent ones of the isolation structures 101; the bit line structures 20 are formed on the substrate 10, the bit line structures 20 extending in the first direction X and being disposed at intervals in the second direction Y, the bit line structures 20 having a specific height in a third direction, the first direction X being perpendicular to the second direction Y, and the first openings 301 each being present between adjacent ones of the bit line structures 20.

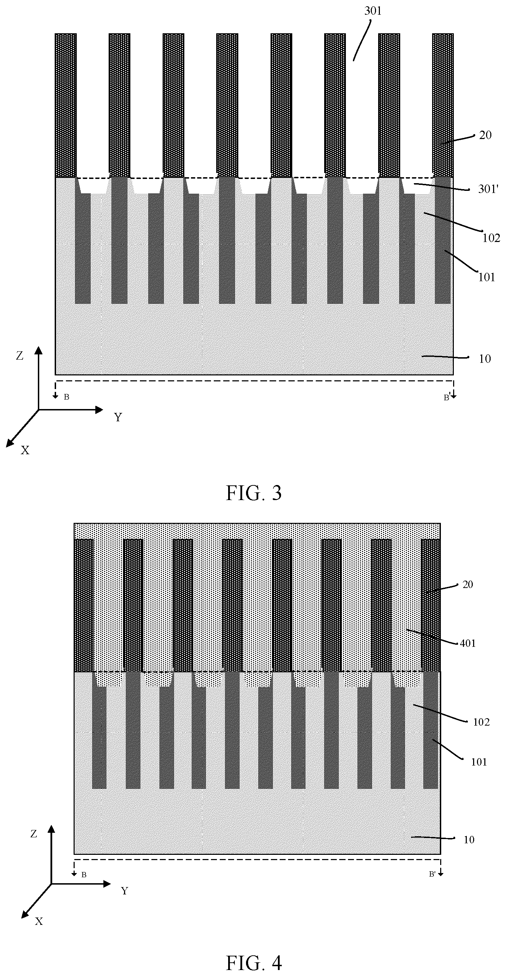

Next, referring to FIG. 4, the first conductive layer 401 is formed in the first openings 301, the first conductive layer 401 further covering the tops of the bit line structures 20.

Further, referring to FIG. 3, before the first conductive layer 401 is formed, the forming method further includes the following step: the substrate 10 continues to be etched along the first openings 301 to form first initial openings 301', the first initial openings 301' being further filled with the first conductive layer 401.

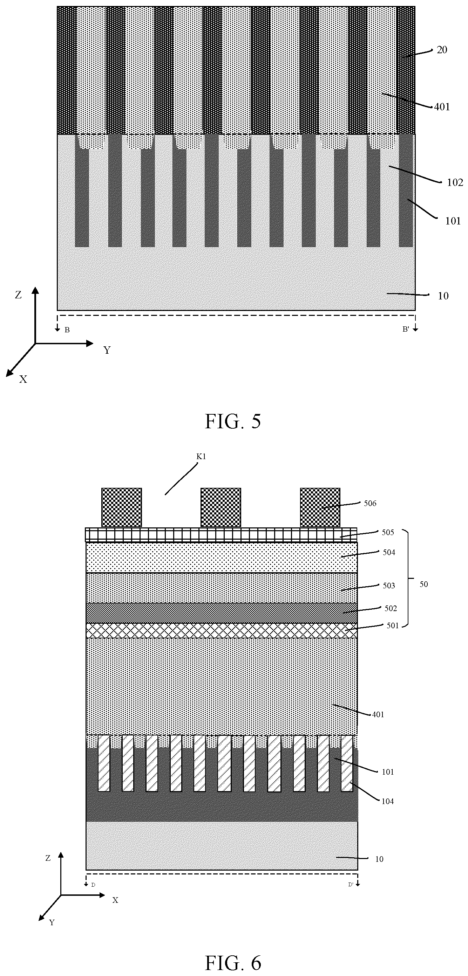

Next, referring to FIG. 5, a part of the first conductive layer 401 above the bit line structures 20 is removed. Specifically, a chemical mechanical polishing (CMP) process may be employed to remove the part of the first conductive layer 401 above the bit line structures 20.

Referring to FIG. 6 to FIG. 11, before the first conductive layer 401 is etched in the third direction Z to form the second openings 302, the forming method further includes the following steps: a stacked film layer 50 is formed on the first conductive layer 401, the stacked film layer 50 is etched to form second initial openings 302', and the first conductive layer 401 is etched along the second initial openings 302' to form the second openings 302.

Specifically, referring to FIG. 6, the stacked film layer 50 is formed on the first conductive layer 401, and a photoresist layer 506 is formed on the stacked film layer 50. The photoresist layer 506 has first photoresist openings K1. The stacked film layer 50 includes a first film layer 501, a second film layer 502, a third film layer 503, a fourth film layer 504, and a fifth film layer 505 that are sequentially arranged from bottom to top. The fifth film layer 505 may be an anti-reflection layer. The first film layer 501, the second film layer 502, the third film layer 503, and the fourth film layer 504 may be hard mask layers. The first film layer 501, the second film layer 502, the third film layer 503, the fourth film layer 504, and the fifth film layer 505 each may include one or more layers. In an embodiment, the fifth film layer 505 may be carbonhydrogen oxidized silicon. The first film layer 501, the second film layer 502, the third film layer 503, and the fourth film layer 504 may be one or more of a spin on hardmask (SOH), silicon oxynitride, silicon oxide, or amorphous carbon.

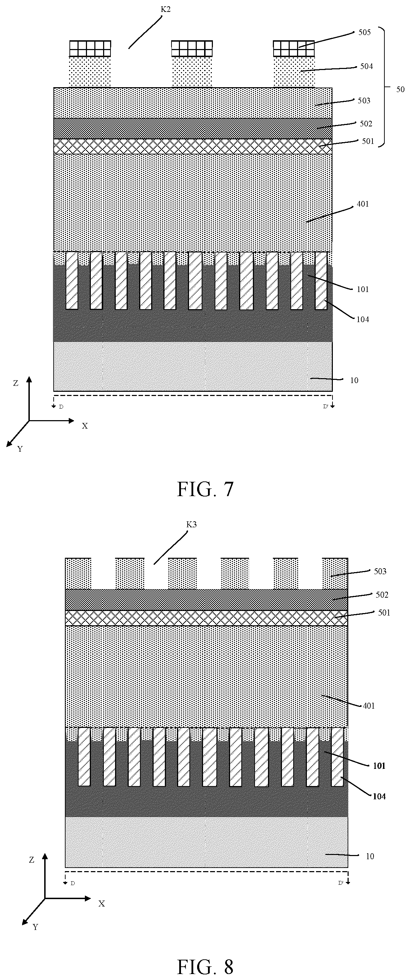

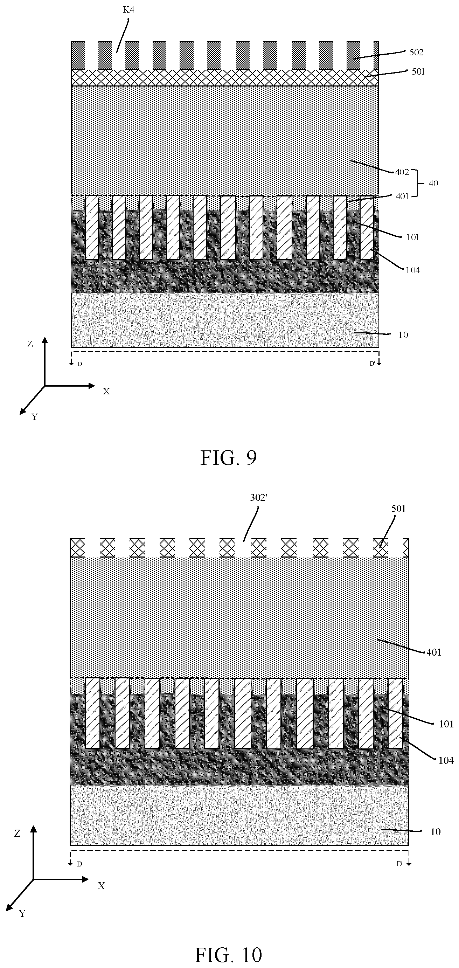

Referring to FIG. 7, the fifth film layer 505 and the fourth film layer 504 are further etched through the first photoresist openings K1 to form second photoresist openings K2. Referring further to FIG. 8, self-aligned double patterning (SADP) is employed to continue to etch the third film layer 503, so that a feature density of the second photoresist openings K2 is doubled to form third photoresist openings K3. Next, referring to FIG. 9, the SADP process is still employed to etch the second film layer 502 to form fourth photoresist openings K4, and a density of the fourth photoresist openings K4 is twice as high as that of the third photoresist openings K3. Next,

**EP 4 770 308 A1**

referring to FIG. 9 to FIG. 10, the first film layer 501 is further etched along the fourth photoresist openings K4 to form the second initial openings 302'.

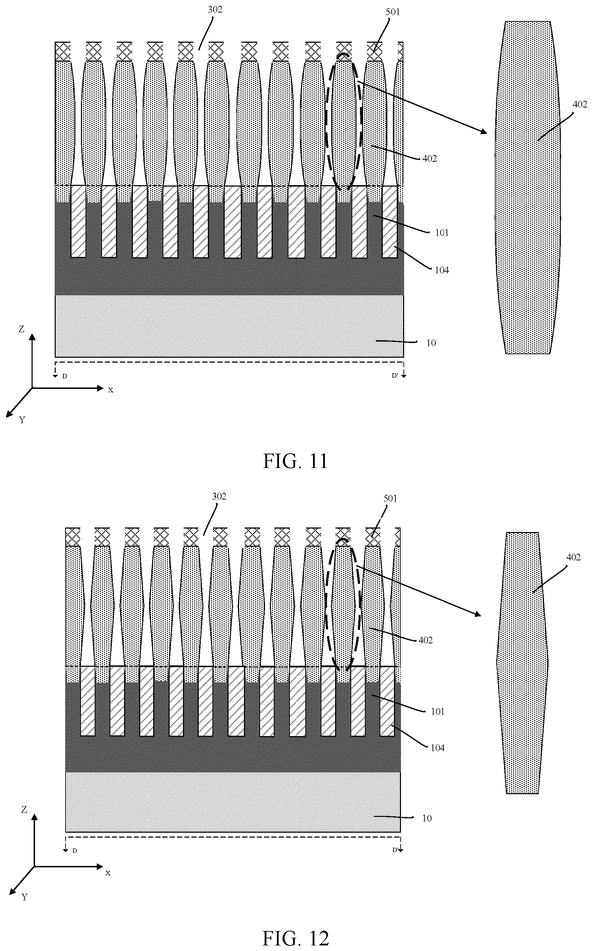

Next, referring to FIG. 11, the first conductive layer 401 continues to be etched along the second initial openings 302', and the remainders of the first conductive layer 401 serve as the second conductive layers 402. Each of the second conductive layers 402 is first increased and then decreased in size from the top to a surface of the substrate 10. Specifically, as shown in an enlarged diagram outlined by a dashed line in FIG. 11, each of the second conductive layers 402 is first increased and then decreased in size from the top to the surface of the substrate 10 in the third direction Z, and the second conductive layer 402 presents a "rugby shape", that is, has an arcuate side edge. In another embodiment, as shown in FIG. 12, each of the second conductive layers 402 is first increased and then decreased in size from the top to the surface of the substrate 10 in the third direction Z, a side edge of the second conductive layer 402 is linear, and the middle part of the second conductive layer 402 is the largest in size. A specific forming method for the second conductive layers 402 includes the following step: an oxidation process, an etching process, and a deoxidation process are cyclically performed, so that each of the second conductive layers 402 is first increased and then decreased in size from the top to the surface of the substrate 10 in the third direction Z. Specifically, the oxidation process is performed through oxygen, a bias power for the oxidation process is gradually increased, and a flow rate of the oxygen is gradually increased; an etching gas for the etching process is chlorine and/or a hydrogen bromide gas, a regulating gas for the etching process is oxygen, a flow rate of the etching gas remains unchanged, and a flow rate of the regulating gas is first increased and then decreased; and the deoxidation process removes, through a plasma, a by-product produced during the etching, and a bias power of the deoxidation process is gradually increased.

The following describes in detail a cyclic procedure of the oxidation process, the etching process, and the deoxidation process for forming the second conductive layers 402. Before a wafer enters a process chamber for cycling of the oxidation process, the etching process, and the deoxidation process, a natural oxide layer may be present on a wafer surface thereof. Therefore, the deoxidation process needs to be first employed to remove the natural oxide layer possibly present on the wafer surface. To be specific, a natural oxide layer may be present on surfaces exposed by the second initial openings 302' shown in FIG. 10. Therefore, before the cycling of the oxidation process, the etching process, and the deoxidation process, the natural oxide layer is first removed through the deoxidation process. The deoxidation process herein mainly removes the natural oxide layer present on the surfaces through plasma bombardment. Then, during actual implementation, the oxidation process, the etching process, and the deoxidation process are performed cyclically along the second initial openings 302' with the first film layer 501 serving as a mask. The oxidation process needs to be first performed because an etched sidewall need to be protected during etching of the first conductive layer 401. Therefore, the oxidation process is performed on a sidewall first at the beginning of each cycle. Although both a sidewall and a bottom are oxidized during oxidation, an oxide layer at the bottom can be removed and the first conductive layer 401 is further etched as the immediately following etching process is directional, i.e., etching is performed vertically. A by-product is produced in the etching process, and needs to be removed by bombardment. This procedure is the deoxidation process, and the first conductive layer 401 can be etched through the foregoing cycle.

To adjust the second conductive layers 402 formed by etching into the "rugby shape" in FIG. 11 or the shape in FIG. 12, a gas trend in each cyclic process is as follows: First, the oxidation process is mainly to protect a sidewall, and therefore a higher oxygen concentration leads to a better oxidation effect and better protection for the sidewall. As the etching proceeds, a depth-to-width ratio of the second openings 302 keeps increasing, and an elevated oxygen concentration is needed to allow for presence of oxygen at the bottom of the second openings 302. Therefore, in a procedure of etching the first conductive layer 401 to form the second conductive layers, an oxygen flow rate is gradually increased, and an adjustment range of the oxygen flow rate is 30 sccm to 100 sccm. In the oxidation process, a larger bias power causes more oxygen to reach the bottoms of the second openings 302, and can improve a density and activity of a plasma. This helps improve a rate and efficiency of an oxidation reaction. Therefore, in the oxidation process, a bias power needs to be gradually increased with a depth, and an adjustment range of the bias power for etching is 0 V to 50 V. That is, the oxygen flow rate and the bias power are gradually increased in the oxidation process. During etching, a main etching gas is chlorine ($Cl_2$) and/or a hydrogen bromide gas (HBr), nitrogen fluoride (NF3) and helium (He) are auxiliary gases, and oxygen ($O_2$) is a regulating gas. To be specific, in the etching process, nitrogen fluoride and helium as carrier gases carry the etching gas into the process chamber. During the etching, as $O_2$ can react with silicon to produce Si-O keys, increasing the amount of $O_2$ can lead to production of more Si-O keys through reaction, and further can suppress production rates of $SiCl_4$ and $SiBr_4$, so that the second conductive layers produced by etching are increased in size (CD); or otherwise, decreasing the amount of $O_2$ causes the size CD of the second conductive layers to decrease. In other words, in the etching process, $O_2$ serves as a protective gas. Throughout the etching, the amounts of $Cl_2$/HBr and $NF_3$/He are constantly kept within certain ranges, but the flow rate of $O_2$ needs to be first increased and then decreased, i.e., the flow rate of $O_2$ keeps increasing until the CD of the second conductive layers reaches the maximum value, and the flow rate of $O_2$ is gradually decreased after the CD of the second conductive layers reaches the maximum value. In addition, the deoxidation procedure is actually a procedure of bombarding a by-product through a plasma and then removing the by-product. Because a by-product at the bottom of the second openings 302 is relatively difficult to remove as an etching depth increases, it is necessary to increase the bias power to improve efficiency of removing an oxide layer and the by-product at the bottom. Therefore, during etching of the first conductive layer 401 to form the second conductive layers, the bias power of the deoxidation process is gradually increased, and an adjustment range of the bias power is 0 V to 300 V. A larger bias power leads to better clearing of the oxide layer and the by-product at the bottom and less consumption of an oxide layer on a sidewall. Each of the second conductive layers 402 is adjusted into the "rugby shape" in FIG. 11 or the shape in FIG. 12 through adjustment of the procedure of the foregoing processes and cycling of oxidation, etching, and deoxidation.

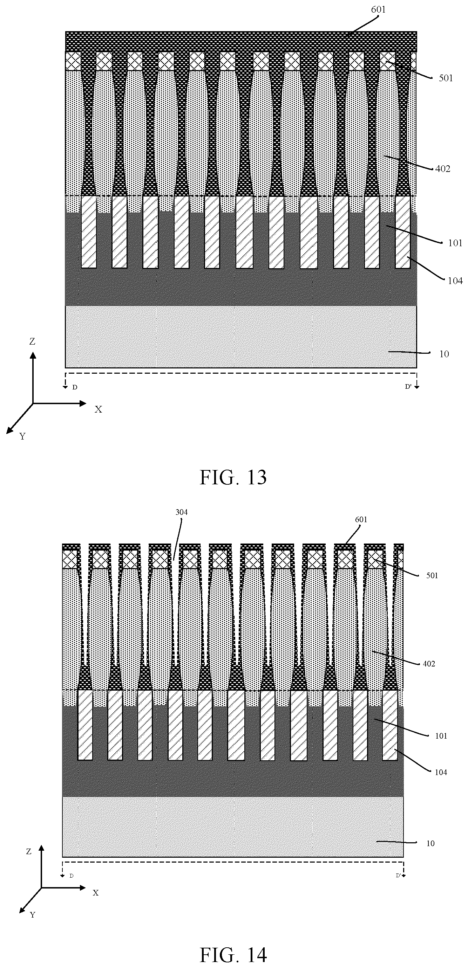

In this application, the "rugby shape" in FIG. 11 is taken as an example for a subsequent process. It should be noted that the subsequent process is also applicable to FIG. 12. Next, referring to FIG. 13 to FIG. 15, that the second openings 302 are filled with first dielectric layers 60 specifically includes the following step: the second openings 302 are filled with a first initial dielectric layer 601, the first initial dielectric layer 601 further covering surfaces of the second conductive layers 402; the first initial dielectric layer 601 is etched back to form fourth openings 304; a second initial dielectric layer 602 is formed in the fourth openings 304; and the first dielectric layers 60 are formed by the first initial dielectric layer 601 and the second initial dielectric layer 602 together. Specifically, as shown in FIG. 14, the fourth openings 304 may be V-shaped. The fourth openings 304 can remove bubbles produced during filling of the first initial dielectric layer 601. In a specific embodiment, a depth of the first initial dielectric layer 601 from the top of the first film layer 501 to the bottom of the first initial dielectric layer 601 in the Z direction is $H_1$, and a depth of the fourth openings 304 from the top of the first film layer 501 to the bottoms of the fourth openings 304 in the Z direction is $H_2$.

$$\frac{2}{3}H_1 \ll H_2 \leq \frac{4}{5}H_1$$ To be specific, the depth $H_2$ of the fourth openings 304 is greater than or equal to 2/3 of $H_1$ and less than or equal to 4/5 of $H_1$, i.e., the depth of the fourth openings 304 exceeds a half of the depth of the first initial dielectric layer 601, in other words, the depth of the fourth openings 304 exceeds a position, of each of the second conductive layers 402, having the maximum size. Next, referring to FIG. 15, the fourth openings 304 are further filled with the second initial dielectric layer 602. The first initial dielectric layer 601 and the second initial dielectric layer 602 together form each of the first dielectric layers 60. Bubbles may be produced in a middle and lower part during filling due to the relatively large depth-to-width ratio of the original second openings 302. However, as a depth-to-width ratio of the fourth openings 304 decreases, bubbles are not produced in the newly filled second initial dielectric layer 602, and film layer quality of the first dielectric layers 60 is improved. In a specific embodiment, the forming method further includes the following step: The CMP process is employed to remove a part of each of the first dielectric layers 60 at the top of the first film layer 501, where remainders of the first dielectric layers 60 are first decreased and then increased in size from top to bottom, i.e., the middle part of the first dielectric layer 60 is the largest in size. In a specific embodiment, as shown in FIG. 15, the first dielectric layer further has an air gap 90 therein, and the air gap 90 is lower than the lowest part of the second initial dielectric layer 602. Because a conductivity of the air gap 90 is less than that of the first dielectric layer 60, the presence of the air gap 90 can better isolate adjacent ones of the second conductive layers 402.

Next, referring further to FIG. 16, the second conductive layers 402 are etched back in the third direction Z to form third openings 303, and remainders of the second conductive layers 402 serve as contact structures 70. Each of the contact structures 70 includes a first contact structure 701 and a second contact structure 702, the first contact structure 701 is located in one of the first initial openings 301', the second contact structure 702 is located above the first contact structure 701, and the second contact structure 702 is gradually decreased in size from top to bottom in the direction perpendicular to the substrate 10. It should be noted that an end point of the etching back is the position, of each of the second conductive layers 402, having the maximum size, i.e., the top of the contact structure 70 is the largest in size.

FIG. 17 is a schematic top view of FIG. 16. Referring to FIG. 17, the bit line structures 20 extend in the first direction X and are disposed at intervals in the second direction Y, and the first direction X is perpendicular to the second direction Y; each of the first dielectric layers 60 is located between adjacent ones of the bit line structures 20, and the first dielectric layers 60 are disposed at intervals in the first direction X; multiple contact structures 70 are located between adjacent ones of the bit line structures 20, and the contact structures 70 and the first dielectric layers 60 are alternately disposed.

Referring to FIG. 18, the conductive structures 80 are formed in the third openings 303, and the conductive structures 80 are located above the contact structures 70; and each of the conductive structures 80 includes a first conductive structure 801 and a second conductive structure 802, the first conductive structure 801 is located in one of the third openings 303 and flush with top surfaces of the first dielectric layers 60, the second conductive structure 802 is located between the first conductive structure 801 and one of the contact structures 70, and the conductive structure 80 is gradually increased in size from top to bottom in the direction perpendicular to the substrate 10. A contact area between the second conductive structure 802 and the contact structure 70 is greater than a cross-sectional area of the conductive structure 80 at any position and greater than a cross-sectional area of the contact structure 70 at any position. In other words, a contact position between the conductive structure 80 and the contact structure 70 is located at a position, of the first dielectric layer 60, having the minimum CD. A contact area between each of the conductive structures 80 and each of the contact structures 70 is greater than the cross-sectional area of the conductive structure 80 at any position and greater than the cross-sectional area of the contact structure 70 at any position. In this way, the maximum contact area can allow for reduction of a value of contact resistance between the contact structure 70 and the conductive structure 80, and improve performance of a connection between the conductive structure and the contact structure.

It can be seen from FIG. 18 that each of the contact structures 70 is gradually decreased in size from the top of the contact structure 70 to the surface of the substrate 10 in the direction perpendicular to the substrate, and each of the conductive structures 80 is gradually increased in size from top to bottom in the direction perpendicular to the substrate 10, so that a contact area between the conductive structure 80 and the contact structure 70 is the largest. As shown in FIG. 10 to FIG. 11, in the conventional technologies, the second conductive layers 402 formed by etching the first conductive layer 401 along the second initial openings 302' do not exhibit a trend of a CD being first increased and then decreased. In other words, the second conductive layers in the conventional technologies do not form the "rugby shape" shown in FIG. 11 or the shape shown in FIG. 12. Actually, in the conventional technologies, the second conductive layers are simply etched and formed based on the size exposed along the second initial openings 302', i.e., the size of each of the second conductive layers from top to bottom is just about the size exposed by the second initial openings 302'. In other words, in the conventional technologies, a CD of a finally formed contact structure does not exhibit a trend of gradual decrease from top to bottom, and the conductive structures do not exhibit a trend of gradual increase from top to bottom. Therefore, there is no maximum contact area between each of the conductive structures and each of the contact structures in the conventional technologies. In this application, by adjusting the cyclic procedure of the oxidation process, the etching process, and the deoxidation process, the second conductive layers 402 are first increased and then decreased in size from the tops of the second conductive layers 402 to the surface of the substrate 10 in the direction perpendicular to the substrate 10, so that the contact area between the finally formed conductive structure 80 and contact structure 70 is the largest, and the performance of the connection between the conductive structure 80 and the contact structure 70 is improved. In addition, as shown in FIG. 18, each of the first dielectric layers 60 is first decreased and then increased in size from top to bottom, i.e., the first dielectric layer 60 presents a shape similar to an "inverted trapezoid" at a position corresponding to the conductive structure 80. In this way, an interval between adjacent conductive structures is increased, and a short circuit caused by an excessively short distance between adjacent isolation structures is prevented. In addition, because the second openings 302 exhibit a trend of being first decreased and then increased in CD from top to bottom, a relatively large top opening can prevent occurrence of an air gap at the top during formation of the first dielectric layers 60. Similarly, the first dielectric layer 60 presents a shape similar to a "trapezoid" at a position corresponding to the contact structure 70. In this way, an interval between adjacent ones of the contact structures 70 is increased, and a short circuit caused by an excessively short distance between adjacent ones of the contact structure 70 is prevented. In the conventional technologies, a short circuit is most prone to occur at the bottom of a contact structure and the top of a conductive structure. In this application, each of the first dielectric layers 60 has a larger CD at the tops of the conductive structures 80 and the bottoms of the contact structures 70, thereby improving an isolation effect between adjacent ones of the conductive structures 80 and between adjacent ones of the contact structures 70, preventing occurrence of a short circuit, and improving performance of the semiconductor structure. In another embodiment, each of the first dielectric layers 60 further has an air gap 90 therein, and the air gap 90 is lower than an interface between each of the conductive structures 80 and each of the contact structures 70. Specifically, the air gap 90 is lower than the bottom of the second initial dielectric layer 602. Because a conductivity of the air gap 90 is less than that of the first dielectric layer 60, the presence of the air gap 90 can better isolate adjacent ones of the contact structures 70, thereby further preventing occurrence of a short circuit between adjacent ones of the contact structures 70. Certainly, in another embodiment, there may be no air gap 90 in the first dielectric layer 60. In a specific embodiment, each of the contact structures 70 may be polysilicon, the first conductive structure 801 may be one or more of copper, tungsten, titanium, or titanium nitride, and the second conductive structure may be one or more of cobalt silicide, titanium silicide, or nickel silicide.

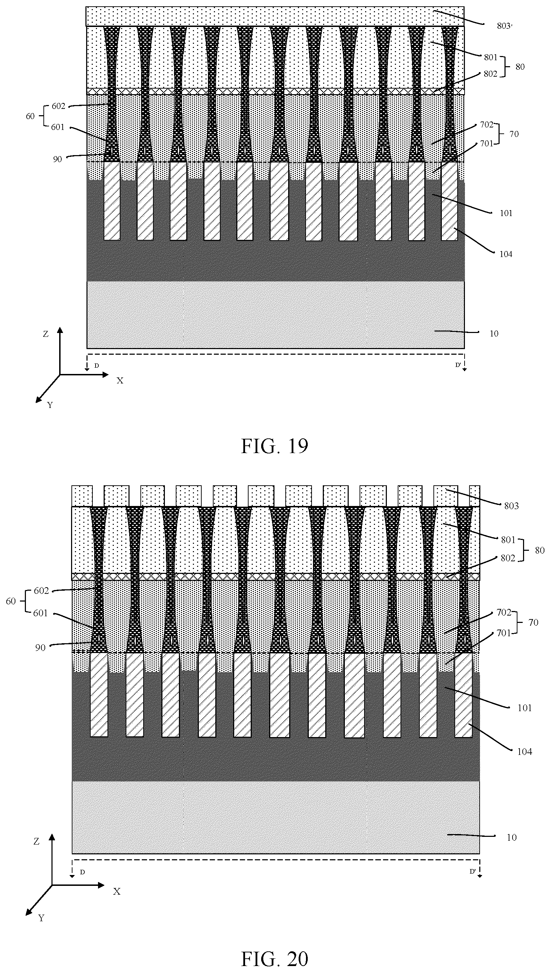

Next, referring to FIG. 19, in another embodiment, that conductive structures 80 are formed in the third openings 303 further includes the following step: an initial top conductive structure 803' is formed above the conductive structures 80. The initial top conductive structure 803' is located above the conductive structures 80 and covers top surfaces of the first dielectric layers 60. It should be noted that the initial top conductive structure 803' and the conductive structures 80 may be simultaneously formed, or may be formed in different steps, to be specific, the initial top conductive structure 803' may be formed after the conductive structures 80.

Next, referring to FIG. 20, parts of the initial top conductive structure 803' are etched to expose parts of the tops of the first dielectric layers 60, and remainders of the initial top conductive structure 803' form top conductive structures 803. The top conductive structures 803 are formed above the conductive structures 80 and cover parts of top surfaces of the first dielectric layers 60, and the top conductive structures 803 and the conductive structures 80 may together form a landing pad (LP) structure. The contact structures 70 may serve as node contacts (NC), and a material of the top conductive structures 803 may be one or more of copper, tungsten, titanium, or titanium nitride.

In the embodiments of this application, by adjusting the cyclic procedure of the oxidation process, the etching process, and the deoxidation process, the second conductive layers 402 are first increased and then decreased in size from the tops of the second conductive layers 402 to the surface of the substrate 10 in the direction perpendicular to the substrate 10, so that the contact area between the finally formed conductive structure 80 and contact structure 70 is the largest, and the performance of the connection between the conductive structure 80 and the contact structure 70 is improved. Each of the first dielectric layers 60 is first decreased and then increased in size from top to bottom, thereby improving an isolation effect between adjacent ones of the conductive structures 80 and between adjacent ones of the contact structures 70, preventing occurrence of a short circuit, and improving performance of the semiconductor structure.

FIG. 21 is a schematic diagram of a semiconductor structure according to an embodiment of the present disclosure. An enlarged structure in a dashed-line frame is shown on the right. Referring to FIG. 17 and FIG. 21, a semiconductor structure includes the following: a substrate 10; bit line structures 20, located on the substrate 10, multiple bit line structures 20 extending in a first direction X and being disposed at intervals in a second direction Y, and the first direction X being perpendicular to the second direction Y; first dielectric layers 60, each of the first dielectric layers 60 being located between adjacent ones of the bit line structures 20, and the first dielectric layers 60 being disposed at intervals in the first direction X; contact structures 70, each of the contact structures 70 being located between adjacent ones of the bit line structures 20, and the contact structures 70 and the first dielectric layers 60 being alternately disposed; and conductive structures 80, located above the contact structures 70, the tops of the conductive structures 80 being flush with the tops of the first dielectric layers 60; the contact structures 70 being gradually decreased in size from the tops of the contact structures 70 to a surface of the substrate 10 in a direction perpendicular to the substrate 10, i.e., a Z direction. Each of the conductive structures 80 includes a first conductive structure 801 and a second conductive structure 802, the first conductive structure 801 is flush with top surfaces of the first dielectric layers 60, the second conductive structure 802 is located between the first conductive structure 801 and one of the contact structures 70, and the conductive structure 80 is gradually increased in size from top to bottom in the direction perpendicular to the substrate 10. A contact area between the second conductive structure 802 and each of the contact structures 70 is greater than a cross-sectional area of the conductive structure 80 at any position and greater than a cross-sectional area of the contact structure 70 at any position. In an embodiment, the semiconductor structure further includes top conductive structures 803, located above the conductive structures 80 and covering parts of top surfaces of the first dielectric layers 60. Each of the first dielectric layers 60 is first decreased and then increased in size from top to bottom. In a specific embodiment, the first dielectric layer 60 further has an air gap 90 therein, and the air gap 90 is lower than an interface between each of the conductive structures 80 and each of the contact structures 70. Each of the contact structures 70 includes a first contact structure 701 and a second contact structure 701, the first contact structure 701 is embedded in the substrate 10, the second contact structure 702 is located above the first contact structure, and the second contact structure 702 is gradually decreased in size from top to bottom in the direction perpendicular to the substrate 10. Embedding the first contact structure 701 in the substrate 10 enables a contact area between the contact structure 70 and the substrate 10 to increase. As shown in FIG. 21, each of the conductive structures 80 and each of the contact structures 70 together form a "rugby" shape. Each of the conductive structures 80 is gradually increased in size from top to bottom in the direction perpendicular to the substrate 10, and is gradually decreased in size from the top of the contact structure 70 to the surface of the substrate 10. Cross sections of the conductive structures 80 and those of the contact structures 70 are each arcuate.

FIG. 22 is a schematic diagram of a semiconductor structure according to another embodiment of the present disclosure. An enlarged structure in a dashed-line frame is shown on the right. Parts same as those in FIG. 21 are not described again. A difference is that cross sections of the conductive structures 80 and those of the contact structures 70 are each linear.

Referring to FIG. 21 and FIG. 22, in the semiconductor structure of this application, a size is CD3 at a position at which each of the contact structures 70 is flush with the substrate 10, a size is CD2 at the top of each of the conductive structures 80, and a size is CD1 at a position of a contact interface between each of the contact structures 70 and each of the conductive structures 80. In other words, a contact area between each of the conductive structures 80 and each of the contact structures 70 is greater than a cross-sectional area of the conductive structure 80 at any position and greater than a cross-sectional area of the contact structure 70 at any position. In the conventional technologies, a CD of a finally formed contact structure does not exhibit a trend of gradual decrease from top to bottom, and the conductive structures do not exhibit a trend of gradual increase from top to bottom. Therefore, there is no maximum contact area between each of the conductive structures and each of the contact structures in the conventional technologies. In this application, a contact area between the conductive structure 80 and the contact structure 70 is the largest, and the performance of a connection between the conductive structure 80 and the contact structure 70 is improved. Each of the first dielectric layers 60 is first decreased and then increased in size from top to bottom, i.e., the first dielectric layer 60 presents a shape similar to an "inverted trapezoid" at a position corresponding to the conductive structure 80. In this way, an interval between adjacent conductive structures is increased, and a short circuit caused by an excessively short distance between adjacent isolation structures is prevented. Similarly, the first dielectric layer 60 presents a shape similar to a "trapezoid" at a position corresponding to the contact structure 70. In this way, an interval between adjacent ones of the contact structures 70 is increased, and a short circuit caused by an excessively short distance between adjacent ones of the contact structure 70 is prevented. In the conventional technologies, a short circuit is most prone to occur at the bottom of a contact structure and the top of a conductive structure. In this application, each of the first dielectric layers 60 has a larger CD at the tops of the conductive structures 80 and the bottoms of the contact structures 70, thereby improving an isolation effect between adjacent ones of the conductive structures 80 and between adjacent ones of the contact structures 70, preventing occurrence of a short circuit, and improving performance of the semiconductor structure.

A person of ordinary skill in the art may understand that the foregoing implementations are specific embodiments for implementing the present disclosure. In actual application, various changes may be made to the forms and details of the implementations without departing from the spirit and scope of the embodiments of the present disclosure. Any person skilled in the art may make variations and modifications without departing from the spirit and scope of the present disclosure. Therefore, the protection scope of the present disclosure shall be subject to the scope defined by the claims.

**Claims**

1. A semiconductor structure, comprising:

   a substrate (10);
   bit line structures (20), located on the substrate (10), a plurality of bit line structures (20) extending in a first direction (X) and being disposed at intervals in a second direction (Y), and the first direction (X) being perpendicular to the second direction (Y);
   first dielectric layers (60), each of the first dielectric layers (60) being located between adjacent ones of the bit line structures (20), and the first dielectric layers (60) being disposed at intervals in the first direction (X);
   contact structures (70), each of the contact structures (70) being located between adjacent ones of the bit line structures (20), and the contact structures (70) and the first dielectric layers (60) being alternately disposed; and
   conductive structures (80), located above the contact structures (70), tops of the conductive structures (80) being flush with tops of the first dielectric layers (60);
   the contact structures (70) being gradually decreased in size from tops of the contact structures (70) to a surface of the substrate (10) in a direction perpendicular to the substrate (10).

2. The semiconductor structure according to claim 1, wherein each of the conductive structures (80) comprises a first conductive structure (801) and a second conductive structure (802), the first conductive structure (801) is flush with top surfaces of the first dielectric layers (60), the second conductive structure (802) is located between the first conductive structure (801) and one of the contact structures (70), and the conductive structure (80) is gradually increased in size from top to bottom in the direction perpendicular to the substrate (10).

3. The semiconductor structure according to claim 1, wherein a contact area between each of the conductive structures (80) and each of the contact structures (70) is greater than a cross-sectional area of the conductive structure (80) at any position and greater than a cross-sectional area of the contact structure (70) at any position.

4. The semiconductor structure according to claim 1, further comprising top conductive structures (803), located above the conductive structures (80) and covering parts of top surfaces of the first dielectric layers (60).

5. The semiconductor structure according to claim 1, wherein each of the first dielectric layers (60) is first decreased and then increased in size from top to bottom, the first dielectric layer (60) further has an air gap (90) therein, and the air gap (90) is lower than an interface between each of the conductive structures (80) and each of the contact structures (70).

6. The semiconductor structure according to claim 1, wherein each of the contact structures (70) comprises a first contact structure (701) and a second contact structure (702), the first contact structure (701) is embedded in the substrate (10), the second contact structure (702) is located above the first contact structure (701), and the second contact structure (702) is gradually decreased in size from top to bottom in the direction perpendicular to the substrate (10).

7. A forming method for a semiconductor structure, comprising:

> providing a substrate (10);
> forming bit line structures (20) on the substrate (10), the bit line structures (20) extending in a first direction (X) and being disposed at intervals in a second direction (Y), the first direction (X) being perpendicular to the second direction (Y), and first openings (301) each being present between adjacent ones of the bit line structures (20);
> forming a first conductive layer (401) in the first openings (301);
> etching the first conductive layer (401) in a third direction (Z) to form second openings (302), remainders of the first conductive layer (401) serving as second conductive layers (402), the second conductive layers (402) and the second openings (302) being alternately disposed in the first direction (X), and the third direction (Z) being perpendicular to the substrate (10);
> filling the second openings (302) with first dielectric layer (60);
> etching back the second conductive layers (402) to form third openings (303), remainders of the second conductive layers (402) serving as contact structures (70); and
> forming conductive structures (80) in the third openings (303), the conductive structures (80) being located above the contact structures (70); the contact structures (70) being gradually decreased in size from tops of the contact structures (70) to a surface of the substrate (10) in a direction perpendicular to the substrate (10).

8. The forming method for a semiconductor structure according to claim 7, wherein each of the conductive structures (80) comprises a first conductive structure (801) and a second conductive structure (802), the first conductive structure (801) is located in one of the third openings (303) and flush with top surfaces of the first dielectric layers (60), the second conductive structure (802) is located between the first conductive structure (801) and one of the contact structures (70), and the conductive structure (80) is gradually increased in size from top to bottom in the direction perpendicular to the substrate (10).

9. The forming method for a semiconductor structure according to claim 7, wherein a contact area between each of the conductive structures (80) and each of the contact structures (70) is greater than a cross-sectional area of the conductive structure (80) at any position and greater than a cross-sectional area of the contact structure (70) at any position.

10. The forming method for a semiconductor structure according to claim 7, further comprising forming top conductive structures (803) above the conductive structures (80) and covering parts of top surfaces of the first dielectric layers (60).

11. The forming method for a semiconductor structure according to claim 7, wherein each of the first dielectric layers (60) is first decreased and then increased in size from top to bottom, the first dielectric layer (60) further has an air gap (90) therein, and the air gap (90) is lower than an interface between each of the conductive structures (80) and each of the contact structures (70).

12. The forming method for a semiconductor structure according to any one of claims 7 to 11, wherein each of the second conductive layers (402) is first increased and then decreased in size from top to bottom, and a forming method for the second conductive layers (402) comprises the following step: cyclically performing an oxidation process, an etching process, and a deoxidation process.

13. The forming method for a semiconductor structure according to claim 12, wherein the oxidation process is performed through oxygen, a bias power for the oxidation process is gradually increased, and a flow rate of the oxygen is gradually increased; an etching gas for the etching process is chlorine and/or a hydrogen bromide gas, a regulating gas for the etching process is oxygen, a flow rate of the etching gas remains unchanged, and a flow rate of the regulating gas is first increased and then decreased; and the deoxidation process removes, through a plasma, a by-product produced during the etching, and a bias power of the deoxidation process is gradually increased.

14. The forming method for a semiconductor structure according to claim 7, before forming the first conductive layer (401), further comprising: continuing to etch the substrate (10) along the first openings (301) to form first initial openings (301'), the first initial openings (301') being further filled with the first conductive layer (401).

15. The forming method for a semiconductor structure according to claim 14, wherein each of the contact structures (70) comprises a first contact structure (701) and a second contact structure (702), the first contact structure (701) is located in one of the first initial openings (301'), the second contact structure (702) is located above the first contact structure (701), and the second contact structure (702) is gradually decreased in size from top to bottom in the direction perpendicular to the substrate (10).

16. The forming method for a semiconductor structure according to claim 7, before etching the first conductive layer (401) in the third direction (Z) to form the second openings (302), further comprising: forming a stacked film layer (50) on the first conductive layer (401), etching the stacked film layer (50) to form second initial openings (302'), and etching the first conductive layer (401) along the second initial openings (302') to form the second openings (302).

17. The forming method for a semiconductor structure according to claim 7, wherein filling the second openings (302) with the first dielectric layers (60) specifically comprises the following step:
filling the second openings (302) with a first initial dielectric layer (601), the first initial dielectric layer (601) further covering surfaces of the second conductive layers (402); etching back the first initial dielectric layer (601) to form fourth openings (304); forming a second initial dielectric layer (602) in the fourth openings (304); and forming the first dielectric layers (60) by the first initial dielectric layer (601) and the second initial dielectric layer (602) together.

FIG. 1

FIG. 2

301

20

301'

102

101

10

Z

B

Y

X

B'

FIG. 3

20

401

102

101

10

Z

B

Y

X

B'

FIG. 4

FIG. 5

FIG. 6

FIG. 7

FIG. 8

FIG. 9

FIG. 10

FIG. 11

FIG. 12

601

501

402

101

104

Z

X

Y

D

D'

10

FIG. 13

304

601

501

402

101

104

Z

X

Y

D

D'

10

FIG. 14

FIG. 15

FIG. 16

FIG. 17

FIG. 18

FIG. 19

FIG. 20

FIG. 21

FIG. 22

## INTERNATIONAL SEARCH REPORT

| International application No. |
| --- |
| **PCT/CN2025/082240** |

### A. CLASSIFICATION OF SUBJECT MATTER

H10B 12/00(2023.01)i

According to International Patent Classification (IPC) or to both national classification and IPC

### B. FIELDS SEARCHED

Minimum documentation searched (classification system followed by classification symbols)

IPC: H10B

Documentation searched other than minimum documentation to the extent that such documents are included in the fields searched

Electronic data base consulted during the international search (name of data base and, where practicable, search terms used)

CNTXT; ENTXTC; ENTXT: DWPI: WPABS: CNKI: IEEE: 半导体, 存储, 位线, 介质, 层, 接触, 导电, 电阻, 面积, 尺寸, 宽, 变小, 减小, semiconductor, memory, bit line, dielectric, layer, contact, conduct+, resistance, area, dimension+, width, decrease, smaller

### C. DOCUMENTS CONSIDERED TO BE RELEVANT

| Category* | Citation of document, with indication, where appropriate, of the relevant passages | Relevant to claim No. |
| --- | --- | --- |
| A | CN 117500270 A (CHANGXIN JIDIAN (BEIJING) STORAGE TECHNOLOGY CO., LTD.) 02 February 2024 (2024-02-02) description, paragraphs 0046-0112, and figure 7 to figure 16 | 1-17 |
| A | WO 2024109156 A1 (CHANGXIN MEMORY TECHNOLOGIES, INC.) 30 May 2024 (2024-05-30) entire document | 1-17 |
| A | US 2012087171 A1 (LEE SEUNG HYUN) 12 April 2012 (2012-04-12) entire document | 1-17 |

☐ Further documents are listed in the continuation of Box C.    ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **23 June 2025** | **04 July 2025** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2025/082240**

| Patent document cited in search report | | | Publication date (day/month/year) | Patent family member(s) | | | Publication date (day/month/year) |
|---|---|---|---|---|---|---|---|
| CN | 117500270 | A | 02 February 2024 | CN | 117500270 | B | 19 April 2024 |
| WO | 2024109156 | A1 | 30 May 2024 | CN | 118102711 | A | 28 May 2024 |
| US | 2012087171 | A1 | 12 April 2012 | US | 8456888 | B2 | 04 June 2013 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202411538538